# EUROPÄISCHE PATENTANMELDUNG

(11) **EP 4 475 638 A1**
(43) Veröffentlichungstag der Anmeldung: **11.12.2024**
(21) Anmeldenummer: 24180564.7
(22) Anmeldetag: 06.06.2024
(51) Int. Cl.: H05K 3/28

(54) **VERFAHREN ZUM VERGIESSEN EINER LEITERPLATTE MIT EINER VERGUSSMASSE UND EINE VORRICHTUNG ZUM SCHÜTZEN EINER AUF EINER LEITERPLATTE ANGEORDNETEN ELEKTRISCHEN BAUGRUPPE VOR EINER VERGUSSMASSE**

(30) Priorität: 07.06.2023 DE 102023114926
(71) Anmelder: Yamaichi Electronics Deutschland GmbH, 85609 Aschheim-Dornach (DE)
(72) Erfinder: RIECK, Sandro, 83714 Miesbach (DE); FERNÁNDEZ SERRANO, Jaime, 28830 San Fernando de Henares, Madrid (ES)
(74) Vertreter: Müller-Boré & Partner Patentanwälte PartG mbB

(57) **Zusammenfassung**

Die Erfindung betrifft ein Verfahren zum Vergießen einer Leiterplatte mit einer Vergussmasse aufweisend die Schritte: Bereitstellen einer Leiterplatte mit einer darauf angeordneten elektrischen Baugruppe; Bereitstellen einer Vorrichtung zum Schützen der elektrischen Baugruppe vor der Vergussmasse, wobei die Vorrichtung ein rahmenförmiges Element aufweist; Anbringen des rahmenförmigen Elements an der Leiterplatte derart, dass die elektrische Baugruppe innerhalb des rahmenförmigen Elements angeordnet ist und das rahmenförmige Element die elektrische Baugruppe in einer Ebene parallel zu der Leiterplatte einrahmt und/oder umschließt, wobei das rahmenförmige Element die Leiterplatte derart kontaktiert, um ein Eindringen einer Vergussmasse von außerhalb des rahmenförmigen Elements nach innerhalb des rahmenförmigen Elements zu unterbinden; und Aufbringen der Vergussmasse auf die Leiterplatte außerhalb des rahmenförmigen Elements.

## Beschreibung

Die Erfindung betrifft ein Verfahren zum Vergießen einer Leiterplatte mit einer Vergussmasse und eine Vorrichtung zum Schützen einer auf einer Leiterplatte angeordneten elektrischen Baugruppe vor einer Vergussmasse.

Um Komponenten auf einer Leiterplatte (PCB - printed circuit board) vor Umwelteinflüssen, wie beispielsweise Feuchtigkeit, Chemikalien, Hitze und Vibrationen, zu schützen, werden die Leiterplatten und deren Komponenten häufig mit einer Schutzschicht aus nichtleitendem Material überzogen. Die Schutzschicht kann beispielsweise ein Schutzlack sein, welcher auf das Produkt ausgesprüht wird. Allerdings ist die Schutzwirkung eines solchen Schutzlacks begrenzt. Insbesondere gegen Vibrationen, wie sie insbesondere bei der Verwendung in Fahrzeugen auftreten, und ein davon hervorgerufenes Ablösen von Komponenten, insbesondere SMT-Komponenten, bietet ein solcher Schutzlack meist keinen zuverlässigen Schutz.

Ein besserer Schutz kann durch "Eintopfen" bzw. "Potting" erreicht werden, wobei eine flüssige Masse, auch Vergussmasse genannt, über die Leiterplatte und die Komponenten gegossen wird. Nach Verfestigen der Masse ist die Leiterplatte und deren Komponenten zuverlässig gegen Umwelteinflüsse, insbesondere gegen Schäden durch Vibrationen, geschützt. Allerdings kann die verfestigte Masse aufgrund thermischer Volumenänderung auf der Leiterplatte angeordnete Komponenten negativ beeinflussen. Dies ist insbesondere problematisch bei im Wesentlichen lötfreien Kontaktverbindungen und bei Komponenten mit elastisch verformbaren Abschnitten, wie beispielsweise federnden Kontakten, insbesondere elektrischen Kontakten, zum in Eingriff treten mit einem Kabel, insbesondere mit einem Flachbandkabel. Schon geringe Volumenänderungen der verfestigten Masse können eine Verschlechterung oder sogar eine Trennung der Kontaktverbindung, insbesondere einer elektrischen Kontaktverbindung, verursachen.

Es ist daher eine Aufgabe der vorliegenden Erfindung, ein Verfahren zum Vergießen einer Leiterplatte mit einer Vergussmasse sowie eine Vorrichtung zum Schützen einer auf einer Leiterplatte angeordneten elektrischen Baugruppe vor einer Vergussmasse mit einer erhöhten Verbindungssicherheit einer im Wesentlichen lötfrei ausgebildeten, elektrischen und/oder physikalischen Kontaktverbindung zwischen einem Kontaktelement auf einer Leiterplatte und einem Kabel bereitzustellen.

Diese Aufgabe wird durch die Gegenstände der unabhängigen Ansprüche gelöst. Vorteilhafte Ausführungsformen sind in den Unteransprüchen definiert.

Ein erster Aspekt der Erfindung betrifft ein Verfahren zum Vergießen einer Leiterplatte mit einer Vergussmasse aufweisend die Schritte: Bereitstellen einer Leiterplatte mit einer darauf angeordneten elektrischen Baugruppe; Bereitstellen einer Vorrichtung zum Schützen der elektrischen Baugruppe vor der Vergussmasse, wobei die Vorrichtung ein rahmenförmiges Element aufweist; Anbringen des rahmenförmigen Elements an der Leiterplatte derart, dass die elektrische Baugruppe innerhalb des rahmenförmigen Elements angeordnet ist und das rahmenförmige Element die elektrische Baugruppe in einer Ebene parallel zu der Leiterplatte einrahmt und/oder, bevorzugt vollständig, umschließt, wobei das rahmenförmige Element die Leiterplatte derart kontaktiert, um ein Eindringen einer Vergussmasse von außerhalb des rahmenförmigen Elements nach innerhalb des rahmenförmigen Elements zu unterbinden; und Aufbringen der Vergussmasse auf die Leiterplatte außerhalb des rahmenförmigen Elements.

Das Verfahren bietet den Vorteil, dass eine auf der Leiterplatte angeordnete elektrische Baugruppe gezielt nicht von der Vergussmasse überdeckt wird und/oder mit der Vergussmasse in Berührung kommt, sodass deren Funktion und/oder Eigenschaft von der Vergussmasse nicht beeinflusst wird.

Die Leiterplatte bzw. Platine bzw. printed circuit board (PCB) kann ein oder mehrere elektrische Baugruppen und/oder Bauteile, insbesondere Prozessoren, Speicherbausteine, Kondensatoren, Widerstände, Dioden, Transistoren und/oder Kontaktpins, umfassen.

Die von der Vorrichtung zu schützende elektrische Baugruppe kann ein oder mehrere Bauteile und/oder Kontaktelemente aufweisen, welche zum im Wesentlichen lötfreien Ausbilden einer elektrischen und/oder physikalischen Kontaktverbindung mit einem Kabel, insbesondere einer Kontaktfläche eines Flachbandkabels, ausgebildet sind, wie beispielsweise ein oder mehrere federnde Kontaktelemente.

Insbesondere kann die elektrische Baugruppe eine Kontaktleiste mit einer Mehrzahl federnder Kontaktelemente zum Ausbilden einer elektrischen und/oder physikalische Kontaktverbindung mit einem Kabel, insbesondere einem Flachbandkabel, und, optional, eine Aufnahmeeinrichtung zum Aufnehmen eines Endabschnitts eines Flachbandkabels aufzuweisen.

Das rahmenförmige Element bildet bevorzugterweise einen Rahmen aus, welcher, im auf der Leiterplatte angeordneten Zustand, die zu schützende elektrische Baugruppe in einer Ebene parallel zu der Leiterplattenebene einrahmt und/oder umrahmt und/oder umschließt. Vorzugsweise umschließt das rahmenförmige Element die elektrische Baugruppe vollständig und distal umlaufend. Alternativ kann das rahmenförmige Element die elektrische Baugruppe bereichsweise umschließen, wobei vorzugsweise ein oder mehrere Komponenten und/oder Komponentenaufnahmen auf der Leiterplatte zusammen mit dem rahmenförmigen Element eine die elektrische Baugruppe vollständig umlaufende Barriere ausbilden, um diese vor der Vergussmasse zu schützen.

Das rahmenförmige Element ist dabei bevorzugt derart an der Leiterplatte angeordnet, dass eine der Leiterplatte zugewandten und/oder die Leiterplatte kontaktierende Leiterplattenkontaktfläche des rahmenförmigen Elements im Wesentlichen dicht mit der Leiterplatte abschließt. Insbesondere bildet das rahmenförmige Element einen Wall und/oder Damm und/oder eine Barriere aus, welche die elektrische Baugruppe von der Vergussmasse abschirmt.

Die Vergussmasse wird auf die Leiterplatte bevorzugt an einer Stelle außerhalb und neben dem rahmenförmigen Element aufgebracht, insbesondere aufgegossen. Die Vergussmasse kann insbesondere ein oder mehrere der folgenden Materialien aufweisen und/oder aus diesen bestehen: Kunststoff, insbesondere Polyurethan oder Duromer, Silikon-Kautschuk, oder Harz, insbesondere Epoxidharz oder Polyesterharz. Die Vergussmasse kann bevorzugt bei Erwärmen flüssig sein und/oder einen gießbaren Zustand annehmen und bei Abkühlen im Wesentlichen fest und/oder unelastisch sein. Dadurch kann ein vorteilhaftes Vergießen und ein vorteilhafter Schutz der Bauteile erreicht werden.

Bevorzugt ist die Vorrichtung zum Schützen der elektrischen Baugruppe derart ausgebildet, dass die elektrische Baugruppe nach Aufbringen der Vergussmasse auf die Leiterplatte zugänglich ist, insbesondere zum Kontaktieren mit einem Kabel und/oder einer Mess- bzw. Prüfeinrichtung.

Vorzugsweise umfasst das Anbringen des rahmenförmigen Elements an der Leiterplatte ein Befestigen und/oder Fixieren des rahmenförmigen Elements an der Leiterplatte durch eine Befestigungseinrichtung. Dadurch kann auf vorteilhafte Weise sichergestellt werden, dass die Vorrichtung bei Aufbringen der Vergussmasse in vorgegebener Position verbleibt und insbesondere eine Abdichtung gegenüber der Leiterplatte aufrechterhalten bleibt.

Die Befestigungseinrichtung kann ein oder mehrere Schrauben und/oder Stifte aufweisen, welche mit entsprechenden Aufnahmen, beispielsweise Leiterplatten-Abstandshalter und/oder Lochbohrungen in der Leiterplatte, in Eingriff bringbar sind. Alternativ oder zusätzlich kann die Befestigungseinrichtung eingerichtet sein, einen Stoffschluss zwischen dem rahmenförmigen Element und der Leiterplatte auszubilden, insbesondere mittels einem Klebstoff und/oder einem Klebestreifen. Dabei kann die Befestigungseinrichtung ebenfalls ausgebildet sein, eine Abdichtung zwischen dem rahmenförmigen Element und der Leiterplatte auszubilden und/oder diese zu verbessern.

Vorzugsweise weist die elektrische Baugruppe zumindest ein federndes Kontaktelement auf, welches ausgebildet ist, mit einem Kabel, insbesondere einem Flachbandkabel, eine elektrische und/oder physikalische Kontaktverbindung herzustellen, wobei das Verfahren ferner umfasst: in Eingriff bringen eines Kabels, insbesondere eines Flachbandkabels, mit dem zumindest einen federnden Kontaktelement und/oder Anschließen eines Kabels, insbesondere eines Flachbandkabels, an das zumindest eine federnde Kontaktelement.

Das in Eingriff bringen des Kabels mit dem zumindest einen federnden Kontaktelement kann nach dem Aufbringen der Vergussmasse auf die Leiterplatte erfolgen, sodass die Leiterplatte weiterverarbeitet und/oder montiert werden kann, ohne angeschlossenem Kabel. Dies erleichtert die Handhabbarkeit und Logistik, da ein Anschließen des Kabels erst nach finaler Montage der Leiterplatte erfolgen kann.

Alternativ kann das in Eingriff bringen des Kabels mit dem zumindest einen federnden Kontaktelement vor dem Aufbringen der Vergussmasse auf die Leiterplatte erfolgen. Beispielsweise kann ein Abschnitt des Kabels, welches außerhalb des rahmenförmigen Elements angeordnet ist, ebenfalls durch die Vergussmasse vergossen werden. Alternativ oder zusätzlich kann eine Zugänglichkeit der elektrischen Baugruppe nach dem Vergießen eingeschränkt oder nicht ausreichend gewährleistet sein, sodass ein Anschließen des Kabels vor Aufbringen der Vergussmasse vorteilhaft ist.

Vorzugsweise weist die Vorrichtung einen Kappenabschnitt auf, welcher mit dem rahmenförmigen Element verbindbar ist, wobei das Verfahren ferner umfasst: Anordnen des Kappenabschnitts an dem rahmenförmigen Element derart, dass der Kappenabschnitt die elektrische Baugruppe zumindest bereichsweise in einer Höhenrichtung überdeckt und/oder abdeckt. Dadurch kann ein verbesserter Schutz der elektrischen Baugruppe erreicht werden.

Der Kappenabschnitt kann vor dem Aufbringen der Vergussmasse auf dem rahmenförmigen Element angeordnet werden, sodass die elektrische Baugruppe auch in Höhenrichtung von oben vor der Vergussmasse geschützt ist, wobei mit Höhenrichtung eine Richtung orthogonal zu der Leiterplattenebene gemeint ist.

Der Kappenabschnitt kann nach dem Aufbringen der Vergussmasse auf dem rahmenförmigen Element angeordnet werden, sodass eine vorteilhafte Zugänglichkeit der elektrischen Baugruppe, insbesondere zum Anschließen eines Kabels, nach dem Vergießen bestehen bleibt.

Vorzugsweise ist der Kappenabschnitt verlagerbar, insbesondere verschwenkbar, gegenüber dem rahmenförmigen Element mit diesem verbunden, beispielsweise mit einem Scharnier. Dadurch wird bei angeordnetem Kappenabschnitt eine vorteilhafte Zugänglichkeit der elektrischen Baugruppe ermöglicht, beispielsweise um ein Kabel anzuschließen.

Alternativ kann der Kappenabschnitt integral mit dem rahmenförmigen Element ausgebildet sein.

Ein weiterer Aspekt der Erfindung betrifft eine Vorrichtung zum Schützen einer auf einer Leiterplatte angeordneten elektrischen Baugruppe vor einer in einem Vergussverfahren auf die Leiterplatte aufgebrachten Vergussmasse, aufweisend: ein rahmenförmiges Element, welches auf der Leiterplatte derart anordenbar ist, dass die elektrische Baugruppe innerhalbe des rahmenförmigen Elements angeordnet ist und das rahmenförmige Element die elektrische Baugruppe in einer Ebene parallel zur Leiterplatte einrahmt und/oder, bevorzugt vollständig, umschließt, und zumindest eine Befestigungseinrichtung zum Befestigen und/oder Fixieren des rahmenförmigen Elements an der Leiterplatte; wobei das rahmenförmige Element ausgebildet ist, die Leiterplatte derart zu kontaktieren, um ein Endringen einer auf die Leiterplatte außerhalb des rahmenförmigen Elements aufgebrachte Vergussmasse nach innerhalb des rahmenförmigen Elements zu unterbinden.

Die Vorrichtung ist auf vorteilhafte Weise ausgebildet, eine elektrische Baugruppe auf einer Leiterplatte vor der Vergussmasse zu schützen und/oder von der Vergussmasse abzuschirmen.

Die Vorrichtung kann insbesondere ein oder mehrere der im ersten Aspekt beschriebenen Merkmale aufweisen.

Vorzugsweise ist das rahmenförmige Element im Wesentlichen ringförmig oder eckig oder oval ausgebildet. Alternativ oder zusätzlich kann das rahmenförmige Element einen im Wesentlichen runden oder eckigen Querschnitt in einer Ebene parallel zu Leiterplattenebene aufweisen. Das rahmenförmige Element kann insbesondere hohl ausgebildet sein, d.h. im Inneren des rahmenförmigen Elements bzw. Rahmens einen von zwei Seiten zugänglichen Hohlraum ausbilden.

Vorzugsweise weist das rahmenförmige Element eine flache Form auf. Bevorzugt weist das rahmenförmige Element ein Ausmaß in Höhenrichtung und/oder orthogonal zu der Leiterplattenebene und/oder einer von dem rahmenförmigen Element ausgebildete Rahmenebene auf, welches geringer ist als ein Ausmaß in einer Längenrichtung und einer Breitenrichtung parallel zu der Rahmenebene.

Vorzugsweise weist das rahmenförmige Element eine Aufbauhöhe auf, welche größer ist als eine vorgesehene Vergusshöhe und/oder eine angedachte durchschnittliche Schichtdicke der Vergussmasse, sodass die auf die Leiterplatte aufgebrachte Vergussmasse nicht über das rahmenförmige Element von außen nach innen fließen kann und/oder das rahmenförmige Element in Höhenrichtung übersteigt.

Vorzugsweise weist das rahmenförmige Element an seiner, in Höhenrichtung nach unten gerichteten, Leiterplattenkontaktfläche ein Dichtelement zum Abdichten des Rahmenkörpers gegenüber der Leiterplatte auf. Dadurch kann eine verbesserte Abdichtung zwischen dem rahmenförmigen Element und der Leiterplatte erreicht werden. Alternativ kann das rahmenförmige Element gegen die Leiterplatte gepresst oder pressbar sein, so dass die Vergussmasse nicht durch einen Kontaktbereich zwischen dem rahmenförmigen Element und der Leiterplatte in das Innere des rahmenförmigen Elements eindringen kann. Insbesondere kann die Leiterplattenkontaktfläche des rahmenförmigen Elements derart ausgebildet und mit Druck beaufschlagt sein, dass die Vergussmasse nicht zwischen dem rahmenförmigen Element und der Leiterplatte hindurchfließen kann.

Das Dichtelement kann beispielsweise ein flexibles Dichtband und/oder eine Dichtschnur und/oder eine Dichtmasse umfassen. Vorzugsweise ist das Dichtelement einteilig ausgebildet und/oder ist im Wesentlichen durchgehend und/oder vollständig umlaufend um die elektrische Baugruppe vorgesehen. Das Dichtelement kann innerhalb oder außerhalb der Befestigungseinrichtung angeordnet sein und wird bevorzugt durch die Befestigungseinrichtung zumindest bereichsweise gestaucht, um im Wesentlichen dicht gegenüber der Leiterplatte abzuschließen.

Vorzugsweise weist die Vorrichtung einen Kappenabschnitt auf, welcher an einem, in Höhenrichtung, oberen Abschnitt des rahmenförmigen Elements angeordnet und/oder anordenbar ist. Vorzugsweise ist der Kappenabschnitt ausgebildet, einen von dem rahmenförmigen Element eingerahmten und/oder umschlossenen Bereich der Leiterplatte, insbesondere die elektrische Baugruppe, in Höhenrichtung im Wesentlichen vollständig zu überdecken und/oder abzudecken. Dadurch kann ein weiter verbesserter Schutz der elektrischen Baugruppe erreicht werden. Die Schutzkappe kann insbesondere eine Abdeckung auf einer der Leiterplatte gegenüberliegenden Seite des rahmenförmigen Elements ausbilden.

Der Kappenabschnitt kann integral mit dem rahmenförmigen Element ausgebildet sein.

Alternativ kann der Kappenabschnitt verlagerbar, insbesondere verschwenkbar, mit dem rahmenförmigen Element verbindbar sein. Dies ermöglicht eine verbesserte Zugänglichkeit der elektrischen Baugruppe bei angeordnetem Kappenabschnitt, insbesondere zum Anschließen eines Kabels an die elektrische Baugruppe.

Vorzugsweise weist die Vorrichtung eine Arretiereinrichtung zum Arretieren des verlagerbaren Kappenabschnitts an dem rahmenförmigen Element auf. Bevorzugt ist die Arretierung ausgebildet, den Kappenabschnitt lösbar an dem rahmenförmigen Element zumindest temporär zu fixieren.

Vorzugsweise weist die Vorrichtung eine Ausnehmung und/oder Kabeldurchführung auf, durch welche ein Kabel von außen in das Innere des rahmenförmigen Elements geführt werden kann. Eine Kabeldurchführung kann beispielsweise in dem Kappenabschnitt ausgebildet sein. Alternativ oder zusätzlich kann eine Kabeldurchführung bereichsweise zwischen dem rahmenförmigen Element und dem Kappenabschnitt angeordnet sein. Vorzugsweise weist die Kabeldurchführung eine Kabeldichtung auf, welche ein durch die Kabeldurchführung geführtes Kabel gegenüber dieser im Wesentlichen dicht abschließt. Dadurch kann ein weiter verbesserter Schutz der elektrischen Baugruppe erreicht werden.

Vorzugsweise weist die Vorrichtung ein oder mehrere Ankerelemente zum Verankern des rahmenförmigen Elements in einer auf die Leiterplatte aufgebrachten Vergussmasse auf. Dadurch kann eine weiter verbesserte Befestigung der Vorrichtung auf der Leiterplatte erreicht werden, insbesondere bei einer durch die Befestigungseinrichtung ausgebildeten stoffschlüssigen Befestigung des Rahmenelements an der Leiterplatte.

Ein Ankerelement kann insbesondere integral mit dem rahmenförmigen Element ausgebildet sein und beispielsweise sich distal von der Außenseite des rahmenförmigen Elements erstrecken, um zumindest bereichsweise mit der Vergussmasse in Kontakt zu treten. Bevorzugt weist ein Ankerelement einen Steg und/oder eine Fläche auf, welcher bzw. welche zumindest bereichsweise eine geringere Aufbauhöhe aufweist, wie die angedachte Schichtdicke der Vergussmasse, sodass der Steg und/oder die Fläche zumindest bereichsweise von der Vergussmasse überdeckt wird.

Ein weiterer Aspekt der Erfindung betrifft ein System aufweisend: eine Leiterplatte mit einer darauf angeordneten elektrischen Baugruppe, vorzugsweise umfassend zumindest ein federndes Kontaktelement; und eine Vorrichtung zum Schützen einer elektrischen Baugruppe wie im Vorgang beschrieben, wobei die Vorrichtung derart auf der Leiterplatte angeordnet ist, dass diese eine auf die Leiterplatte aufgebrachte Vergussmasse von der elektrischen Baugruppe fernhält.

Das System kann entsprechend der Merkmale der zuvor genannten Aspekte fortgebildet sein.

Im Folgenden werden einzelne Ausführungsformen zur Lösung der Aufgabe anhand der Figuren beispielhaft beschrieben. Dabei weisen die einzelnen beschriebenen Ausführungsformen zum Teil Merkmale auf, die nicht zwingend erforderlich sind, um den beanspruchten Gegenstand auszuführen, die aber in bestimmten Anwendungsfällen gewünschte Eigenschaften bereitstellen. So sollen auch Ausführungsformen als unter die beschriebene technische Lehre fallend offenbart angesehen werden, die nicht alle Merkmale der im Folgenden beschriebenen Ausführungsformen aufweisen. Ferner werden, um unnötige Wiederholungen zu vermeiden, bestimmte Merkmale nur in Bezug auf einzelne der im Folgenden beschriebenen Ausführungsformen erwähnt. Es wird darauf hingewiesen, dass die einzelnen Ausführungsformen daher nicht nur für sich genommen, sondern auch in einer Zusammenschau betrachtet werden sollen. Anhand dieser Zusammenschau wird der Fachmann erkennen, dass einzelne Ausführungsformen auch durch Einbeziehung von einzelnen oder mehreren Merkmalen anderer Ausführungsformen modifiziert werden können. Es wird darauf hingewiesen, dass eine systematische Kombination der einzelnen Ausführungsformen mit einzelnen oder mehreren Merkmalen, die in Bezug auf andere Ausführungsformen beschrieben werden, wünschenswert und sinnvoll sein kann und daher in Erwägung gezogen und auch als von der Beschreibung umfasst angesehen werden soll.

### Kurze Beschreibung der Zeichnungen

- Figur 1: zeigt eine beispielhafte Vorrichtung mit einem Kappenabschnitt auf einer Leiterplatte;
- Figur 2: zeigt eine weitere beispielhafte Vorrichtung, welche eine elektrische Baugruppe auf einer mit einer Vergussmasse überzogenen Leiterplatte umschließt.

### Detaillierte Beschreibung der Zeichnungen

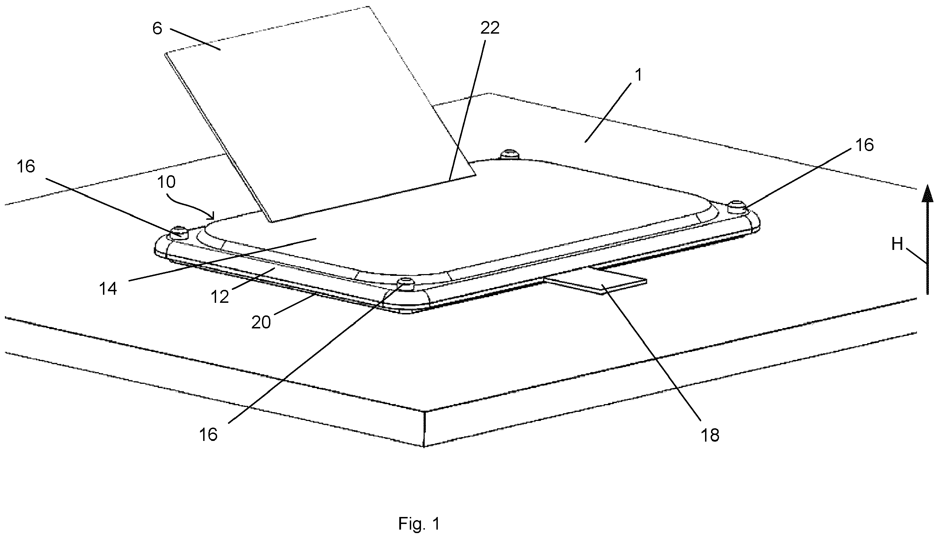

Die **Figur 1** zeigt eine beispielhafte Vorrichtung 10 zum Schützen einer elektrischen Baugruppe 2 vor einer Vergussmasse 8 auf einer Leiterplatte 1. In der Figur 1 ist die Vorrichtung 10 und die Leiterplatte 1 in einem Zustand vor einem Vergussverfahren zum Aufbringen der Vergussmasse 8 auf die Leiterplatte 1 gezeigt.

In dem gezeigten Beispiel weist die Vorrichtung 10 ein rahmenförmiges Element 12 und einen mit diesem integral ausgebildeten Kappenabschnitt 14 auf. Der Kappenabschnitt 14 ist an dem rahmenförmigen Element 12 auf einer der Leiterplatte 1 abgewandten und in Höhenrichtung H oberen Seite des rahmenförmigen Elements 12 angeordnet.

Alternativ kann der Kappenabschnitt 14 lösbar und/oder verlagerbar, insbesondere verschwenkbar, mit dem rahmenförmigen Element 12 verbunden sein.

Vorzugsweise umrahmt und/oder umgibt das rahmenförmige Element 12 eine auf der Leiterplatte 1 angeordnete elektrische Baugruppe 2 (nicht gezeigt). Die im Inneren des rahmenförmigen Elements 12 angeordnete elektrische Baugruppe wird von dem rahmenförmigen Element 12 nach außen hin derart umgeben, dass eine außerhalb des rahmenförmigen Elements 12 auf die Leiterplatte aufgebrachte Vergussmasse 8 (nicht gezeigt) durch das rahmenförmige Element 12 von der elektrischen Baugruppe 2 ferngehalten wird.

Insbesondere bildet das rahmenförmige Element 12 einen Wall und/oder Damm und/oder eine Barriere um die elektrische Baugruppe 2 aus und ist ausgebildet, die elektrische Baugruppe 2 vor der Vergussmasse 8 zu schützen.

Das gezeigte, beispielhafte rahmenförmige Element 12 weist eine im Wesentlichen rechteckige Form mit abgerundeten Ecken auf. Das rahmenförmige Element 12 kann jedoch auch eine andere Form aufweisen, welche ausgebildet ist, die zu schützende elektrische Baugruppe 2 im Wesentlichen vollständig zu umrahmen und/oder in Erstreckungsrichtung der Leiterplattenebene zu umgeben. Vorzugsweise ist das rahmenförmige Element 12 flach ausgebildet, d.h. das rahmenförmige Element weist ein Ausmaß in Höhenrichtung auf, welches deutlich, beispielsweise um einen Faktor 4 oder mehr, geringer ist als ein Ausmaß in Breiten- und Längsrichtung parallel zu der Leiterplattenebene, wobei mit Höhenrichtung H eine Richtung orthogonal zu der Leiterplattenebene gemeint ist.

Insbesondere ist eine Aufbauhöhe des rahmenförmigen Elements 12 größer als eine gedachte und/oder vorgesehene Schichtdicke der (nicht gezeigten) Vergussmasse 8, sodass die Vergussmasse 8 nicht das rahmenförmige Element 12 in Höhenrichtung H übersteigt und in das Innere des rahmenförmigen Elements 12 fließen kann.

Der Kappenabschnitt 14 schützt die elektrische Baugruppe 2 in einer Höhenrichtung H von oben, insbesondere vor einem Vordringen der Vergussmasse 8 in das Innere der Vorrichtung 10. Der Kappenabschnitt 14 des gezeigten Beispiels umfasst eine Ausnahme und/oder Kabeldurchführung 22, durch welche das Innere der Vorrichtung 10 zugänglich ist. Wie abgebildet kann beispielsweise ein Kabel, insbesondere ein Flachbandkabel 6, durch die Kabeldurchführung 22 geführt sein und mit der elektrischen Baugruppe 2 in Eingriff treten. Vorzugsweise ist die Kabeldurchführung 22 derart ausgebildet, dass ein Kabel vor oder nach Montage des Kappenabschnitts 14 in der Kabeldurchführung 22 angeordnet werden kann.

Das rahmenförmige Element 12 ist vorzugsweise mit ein oder mehreren Befestigungseinrichtungen 16 an der Leiterplatte 1 angeordnet und/oder auf der Leiterplatte 1 montiert. Die gezeigte, beispielhafte Vorrichtung 10 weist an jeder Ecke des rahmenförmigen Elements 12 eine Befestigungseinrichtung 16 auf. die Befestigungseinrichtung 16 kann insbesondere eine Schraube sein, welche mit der Leiterplatte 1 oder mit einem unterhalb der Leiterplatte 1 befindlichen Gewinde in Eingriff treten kann und eine in Richtung der Leiterplatte 1 wirkende Kraft auf den Rahmenkörper 12 ausüben kann.

Alternativ oder zusätzlich zu der Befestigungseinrichtung 16 kann das rahmenförmige Element 12 stoffschlüssig mit der Leiterplatte 1 verbunden sein, beispielsweise mittels Klebstoff. Durch einen solchen Stoffschluss kann ferner eine Abdichtung zwischen dem rahmenförmigen Element 12 und der Leiterplatte 1 verbessert werden.

Vorzugsweise weist das rahmenförmige Element 12 ein oder mehrere Dichtelemente 20 auf, zum Abdichten einer in Höhenrichtung H nach unten gerichteten Leiterplattenkontaktfläche des rahmenförmigen Elements 12 gegenüber der Leiterplatte 1. Das Dichtelement 20 ist vorzugsweise einstückig ausgebildet und umlaufend an dem rahmenförmigen Element 12 angeordnet. Bevorzugt ist das Dichtelement 20 flexibel und/oder komprimierbar ausgebildet und/oder eingerichtet, das rahmenförmige Element 12 derart dicht mit der Leiterplatte 1 zu verbinden, dass die Vergussmasse 8 nicht zwischen dem rahmenförmigen Element 12 und der Leiterplatte 1 in das Innere des rahmenförmigen Elements 12 vordringen kann.

Zusätzlich kann die Vorrichtung 10 ein oder mehrere Ankerelemente 18 aufweisen, welche ausgebildet sind, zumindest teilweise vergossen zu werden und/oder von der Vergussmasse 8 überzogen zu werden. Dadurch kann eine verbesserte Fixierung des rahmenförmigen Elements 12 auf der Leiterplatte 1 erreicht werden.

Ein Ankerelement 18 kann insbesondere ein oder mehrere an einer Außenseite des rahmenförmigen Elements 12 angeordnete und distal erstreckende Abschnitte aufweisen. Die Abschnitte sind vorzugsweise im Wesentlichen in Kontakt mit der Leiterplatte 1 und/oder an einem in Höhenrichtung H unteren Bereich des rahmenförmigen Elements 12 angeordnet, sodass diese auch bei geringer Schichtdicke mit der Vergussmasse 8 in Kontakt treten und/oder von dieser eingegossen werden können.

Ein oder mehrere Ankerelemente 18 sind insbesondere von Vorteil bei einer stoffschlüssigen Befestigung des rahmenförmigen Elements 12 an der Leiterplatte 1, da über die Ankerelemente 18 eine zusätzliche und ausdauernde Befestigung an der Leiterplatte 1 erreicht werden kann.

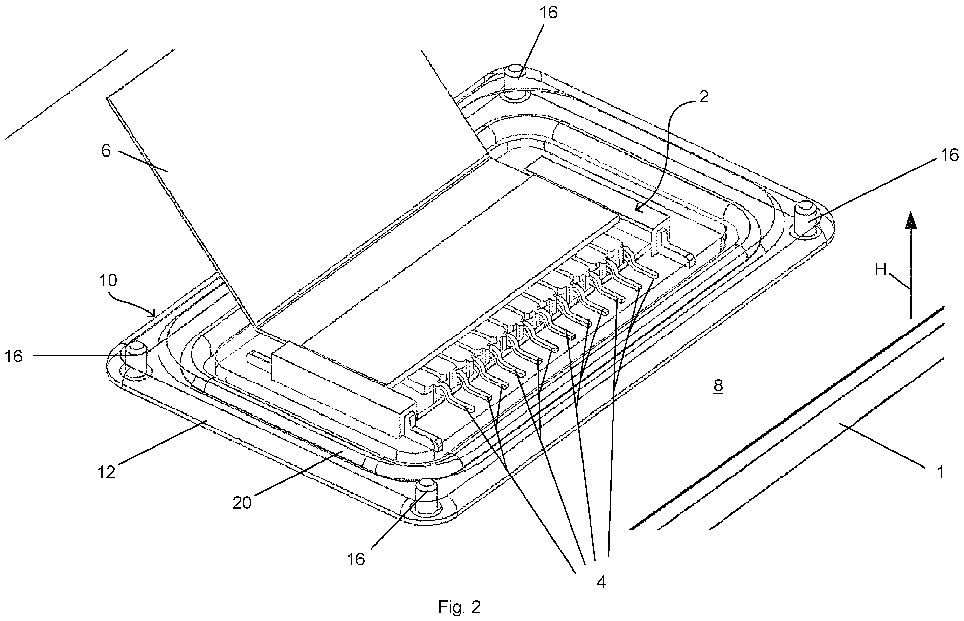

Die **Figur 2** zeigt eine weitere beispielhafte Vorrichtung 10 zum Schützen einer elektrischen Baugruppe 2, wobei die Vorrichtung 10 eine elektrische Baugruppe 2 auf einer mit einer Vergussmasse 8 überzogenen Leiterplatte 1 umschließt.

Die Vorrichtung 10 der Figur 2 umfasst ein rahmenförmiges Element 12, beispielsweise wie die Vorrichtung 10 der Figur 1. Allerdings ist bei der Vorrichtung 10 der Figur 2 kein Kappenabschnitt 14 an dem rahmenförmigen Element 12 angeordnet. Somit ist in dem gezeigten Zustand der Vorrichtung 10 der Figur 2 das Innere des rahmenförmigen Elements 12 vollständig zugänglich, insbesondere um ein Flachbandkabel 6 mit der elektrischen Baugruppe 2 zu verbinden.

Das rahmenförmige Element 12 ist in der Figur 2 als Gittermodel dargestellt, sodass beispielsweise die umlaufende Dichtung 20, welche an einer der Leiterplatte 1 zugewandten, unteren Seite des rahmenförmigen Elements 12 angeordnet ist, sichtbar ist.

Im Inneren des rahmenförmigen Elements 12 ist eine elektrische Baugruppe 2 gezeigt, welche auf der Leiterplatte 1 angeordnet ist und welche eine Mehrzahl federnder Kontaktelemente 4 aufweist. Die federnden Kontaktelemente 4 sind in einer Reihe nebeneinander angeordnet und jeweils eingerichtet, mit einem Flachbandkabel 6 eine elektrische und/oder physikalische Kontaktverbindung auszubilden.

Die elektrische Baugruppe 2 ist von dem rahmenförmigen Element 12 vollständig umlaufend umgeben, sodass die auf die Leiterplatte 1 aufgebrachte Vergussmasse 8 nicht zu der elektrischen Baugruppe 2, insbesondere zu den federnden Kontakten 4, vordringen kann. Das rahmenförmige Element 12 hält die Vergussmasse 8 davon ab, in das Innere der Vorrichtung 10 zu fließen und die elektrische Baugruppe 2 zu erreichen.

Wie in Figur 2 gezeigt ist die Schichtdicke der Vergussmasse 8 geringer als die Aufbauhöhe in Höhenrichtung H des rahmenförmigen Elements 12, sodass die Vergussmasse 8 nicht das rahmenförmige Element 12 in Höhenrichtung H überwinden und in das Innere der Vorrichtung 10 fließen kann.

Das rahmenförmige Element 12 der Figur 2 kann ausgebildet sein, mit einem Kappenabschnitt 14 verbunden zu werden. Vorzugsweise weist der Kappenabschnitt 14 an einem Verbindungsbereich mit dem rahmenförmigen Element 12 eine Ausnahme 22 auf, beispielsweise in der Form eines Rücksprungs, durch welchen das Flachbandkabel 6 bei auf dem rahmenförmigen Element 12 angeordneten Zustand des Kappenabschnitts 14 aus dem Inneren der Vorrichtung 10 nach Außen geführt werden kann.

Dazu kann die Vorrichtung 10 vorzugsweise eine Arretiereinrichtung zum Arretieren des Kappenabschnitts 14 aufweisen zum zumindest temporären Fixieren des Kappenabschnitts 14 an dem rahmenförmigen Element 12.

Das rahmenförmige Element 12 der Figur 2 kann insbesondere in oder mehrere der im Vorgang beschriebenen Merkmale aufweisen.

Die gezeigten Vorrichtungen 10 eignen sich insbesondere für ein Verfahren zum Vergießen einer Leiterplatte 1 mit einer Vergussmasse 8.

Das Verfahren zum Vergießen einer Leiterplatte 1 mit einer Vergussmasse 8 kann insbesondere die folgenden Schritte aufweisen: Bereitstellen einer Leiterplatte 1 mit einer darauf angeordneten elektrischen Baugruppe 2; Bereitstellen einer Vorrichtung 10 zum Schützen der elektrischen Baugruppe 2 vor der Vergussmasse 8, wobei die Vorrichtung 10 ein rahmenförmiges Element 12 aufweist; Anbringen des rahmenförmigen Elements 12 an der Leiterplatte 1 derart, dass die elektrische Baugruppe 2 innerhalb des rahmenförmigen Elements 12 angeordnet ist und das rahmenförmige Element 12 die elektrische Baugruppe 2 in einer Ebene parallel zu der Leiterplatte 1 einrahmt und/oder, bevorzugt vollständig, umschließt, wobei das rahmenförmige Element 12 die Leiterplatte 1 derart kontaktiert, um ein Eindringen einer Vergussmasse 8 von außerhalb des rahmenförmigen Elements 12 nach innerhalb des rahmenförmigen Elements 12 zu unterbinden; und Aufbringen der Vergussmasse 8 auf die Leiterplatte 1 außerhalb des rahmenförmigen Elements 12. Das Verfahren kann ferner umfassen: in Eingriff bringen eines Kabels, insbesondere eines Flachbandkabels 6, mit zumindest einem federnden Kontaktelement 4 der elektrischen Baugruppe 2; und/oder Anordnen eines Kappenabschnitts 14 an dem rahmenförmigen Element 12 derart, dass der Kappenabschnitt 14 die elektrische Baugruppe 2 zumindest bereichsweise in einer Höhenrichtung H überdeckt und/oder abdeckt.

### Bezugszeichenliste

- 1: Leiterplatte
- 2: elektrische Baugruppe
- 4: federndes Kontaktelement
- 6: Flachbandkabel
- 8: Vergussmasse
- 10: Vorrichtung
- 12: rahmenförmiges Element
- 14: Kappenabschnitt
- 16: Befestigungseinrichtung
- 18: Ankerelement
- 20: Dichtelement
- 22: Kabeldurchführung
- H: Höhenrichtung

## Patentansprüche

1. Verfahren zum Vergießen einer Leiterplatte (1) mit einer Vergussmasse (8) aufweisend die Schritte:
Bereitstellen einer Leiterplatte (1) mit einer darauf angeordneten elektrischen Baugruppe (2);
Bereitstellen einer Vorrichtung (10) zum Schützen der elektrischen Baugruppe (2) vor der Vergussmasse (8), wobei die Vorrichtung (10) ein rahmenförmiges Element (12) aufweist;
Anbringen des rahmenförmigen Elements (12) an der Leiterplatte (1) derart, dass die elektrische Baugruppe (2) innerhalb des rahmenförmigen Elements (12) angeordnet ist und das rahmenförmige Element (12) die elektrische Baugruppe (2) in einer Ebene parallel zu der Leiterplatte (1) einrahmt und/oder umschließt,
wobei das rahmenförmige Element (12) die Leiterplatte (1) derart kontaktiert, um ein Eindringen einer Vergussmasse (8) von außerhalb des rahmenförmigen Elements (12) nach innerhalb des rahmenförmigen Elements (12) zu unterbinden; und
Aufbringen der Vergussmasse (8) auf die Leiterplatte (1) außerhalb des rahmenförmigen Elements (12).

2. Verfahren nach Anspruch 1, wobei das Anbringen des rahmenförmigen Elements (12) an der Leiterplatte (1) ein Befestigen und/oder Fixieren des rahmenförmigen Elements an der Leiterplatte (1) durch eine Befestigungseinrichtung (16) umfasst, vorzugsweise durch eine Befestigungseinrichtung (16) aufweisend ein oder mehrere Schrauben und/oder Stifte.

3. Verfahren nach Anspruch 1 oder 2, wobei die elektrische Baugruppe (2) zumindest ein federndes Kontaktelement (4) aufweist, welches ausgebildet ist, mit einem Kabel, insbesondere einem Flachbandkabel (6), eine elektrische und/oder physikalische Kontaktverbindung herzustellen, und das Verfahren ferner umfasst:
in Eingriff bringen eines Kabels, insbesondere eines Flachbandkabels (6), mit dem zumindest einen federnden Kontaktelement (12).

4. Verfahren nach einem der vorangehenden Ansprüche, wobei die Vorrichtung (10) einen Kappenabschnitt (14) aufweist, welcher mit dem rahmenförmigen Element (12) verbindbar ist, und das Verfahren ferner umfasst:
Anordnen des Kappenabschnitts (14) an dem rahmenförmigen Element (12) derart, dass der Kappenabschnitt (14) die elektrische Baugruppe (2) zumindest bereichsweise in einer Höhenrichtung (H) überdeckt und/oder abdeckt.

5. Vorrichtung (10) zum Schützen einer auf einer Leiterplatte (1) angeordneten elektrischen Baugruppe (2) vor einer in einem Vergussverfahren auf die Leiterplatte (1) aufgebrachten Vergussmasse (8), aufweisend:
ein rahmenförmiges Element (12), welches auf der Leiterplatte (1) derart anordenbar ist, dass die elektrische Baugruppe (2) innerhalbe des rahmenförmigen Elements (12) angeordnet ist und das rahmenförmige Element (12) die elektrische Baugruppe (2) in einer Ebene parallel zur Leiterplatte (1) einrahmt und/oder umschließt, und
zumindest eine Befestigungseinrichtung (16) zum Befestigen und/oder Fixieren des rahmenförmigen Elements (12) an der Leiterplatte (1);
wobei das rahmenförmige Element (12) ausgebildet ist, die Leiterplatte (1) derart zu kontaktieren, um ein Endringen einer auf die Leiterplatte (1) außerhalb des rahmenförmigen Elements (12) aufgebrachten Vergussmasse (8) nach innerhalb des rahmenförmigen Elements (12) zu unterbinden.

6. Vorrichtung (10) nach Anspruch 5, wobei das rahmenförmige Element (12) im Wesentlichen ringförmig und/oder eckig und/oder oval ausgebildet ist; und/oder
wobei das rahmenförmige Element (12) eine flache Form aufweist.

7. Vorrichtung nach Anspruch 5 oder 6, wobei die Befestigungseinrichtung (16) ein oder mehrere Schrauben und/oder Stifte aufweist.

8. Vorrichtung (10) nach einem der Ansprüche 5 bis 7, wobei das rahmenförmige Element (12) eine Aufbauhöhe aufweist, welche größer ist als eine vorgesehene Vergusshöhe und/oder Schichtdicke der Vergussmasse (8); und/oder wobei das rahmenförmige Element (12) an einer Leiterplattenkontaktfläche ein Dichtelement (20) zum Abdichten des rahmenförmigen Elements (12) gegenüber der Leiterplatte (1) aufweist.

9. Vorrichtung (10) nach einem der Ansprüche 5 bis 8, wobei die Vorrichtung (10) einen Kappenabschnitt (14) aufweist, welcher an einem oberen Abschnitt des rahmenförmigen Elements (12) angeordnet und/oder anordenbar ist.

10. Vorrichtung (10) nach Anspruch 9, wobei der Kappenabschnitt (14) integral mit dem rahmenförmigen Element (12) ausgebildet ist.

11. Vorrichtung (10) nach Anspruch 9, wobei der Kappenabschnitt (14) verlagerbar, insbesondere verschwenkbar, mit dem rahmenförmigen Element (12) verbindbar ist.

12. Vorrichtung (10) Anspruch 11, wobei die Vorrichtung (10) eine Arretiereinrichtung zum Arretieren des verlagerbaren Kappenabschnitts (14) an dem rahmenförmigen Element (12) aufweist.

13. Vorrichtung (10) nach einem der Ansprüche 9 bis 12, wobei der Kappenabschnitt (14) einen von dem rahmenförmigen Element (12) eingerahmten und/oder umschlossenen Bereich der Leiterplatte (1) in Höhenrichtung im Wesentlichen vollständig überdeckt und/oder abdeckt.

14. Vorrichtung (10) nach einem der Ansprüche 5 bis 13, wobei die Vorrichtung (10) ein oder mehrere Ankerelemente (18) zum Verankern des rahmenförmigen Elements (12) in einer auf die Leiterplatte (1) aufgebrachten Vergussmasse (8) aufweist.

15. System aufweisend:
eine Leiterplatte (1) mit einer darauf angeordneten elektrischen Baugruppe (2), vorzugsweise umfassend zumindest ein federndes Kontaktelement (4); und
eine Vorrichtung (10) gemäß einem der Ansprüche 5-14, wobei die Vorrichtung (10) derart auf der Leiterplatte (1) angeordnet ist, dass diese eine auf die Leiterplatte (1) aufgebrachte Vergussmasse (8) von der elektrischen Baugruppe (2) fernhält.
